(19) Europäisches Patentamt
European Patent Office
Office européen des brevets

(11) **EP 4 589 439 A1**

(12) **EUROPEAN PATENT APPLICATION**
published in accordance with Art. 153(4) EPC

(43) Date of publication:
**23.07.2025  Bulletin 2025/30**

(21) Application number: **22963757.4**

(22) Date of filing: **31.10.2022**

(51) International Patent Classification (IPC):
**G06F 11/26** (2006.01)  **G06F 11/10** (2006.01)

(52) Cooperative Patent Classification (CPC):
**G06F 11/10; G06F 11/26**

(86) International application number:
**PCT/CN2022/128727**

(87) International publication number:
**WO 2024/092437 (10.05.2024 Gazette 2024/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• **LUO, Yilin
Shenzhen, Guangdong 518129 (CN)**
• **YIN, Haifeng
Shenzhen, Guangdong 518129 (CN)**
• **LIU, Zewei
Shenzhen, Guangdong 518129 (CN)**

(74) Representative: **Goddar, Heinz J. et al
Boehmert & Boehmert
Anwaltspartnerschaft mbB
Pettenkoferstrasse 22
80336 München (DE)**

(54) **DATA TRANSMISSION METHOD AND APPARATUS, AND SYSTEM**

(57) This application discloses a data transmission method, apparatus, and system, to reduce an error correction processing delay in a chiplet interconnect system, thereby improving data transmission efficiency. Before sending data, a transmit end performs processing such as single-bit error correction ECC encoding, interleaving, and PAM-N encoding on the raw data. After receiving data, a receive end performs processing such as PAM-N decoding, de-interleaving, and single-bit error correction ECC decoding on the data to restore the raw data. According to this application, error correction is performed by using a single-bit error correction technique in a chiplet interconnect system. Compared with a multi-bit error correction technique or a retransmission technique, this application can provide a lower delay and smaller area power consumption.

FIG. 5

EP 4 589 439 A1

**Description**

TECHNICAL FIELD

This application relates to the field of electronics technologies, and in particular, to a data transmission method, apparatus, and system.

BACKGROUND

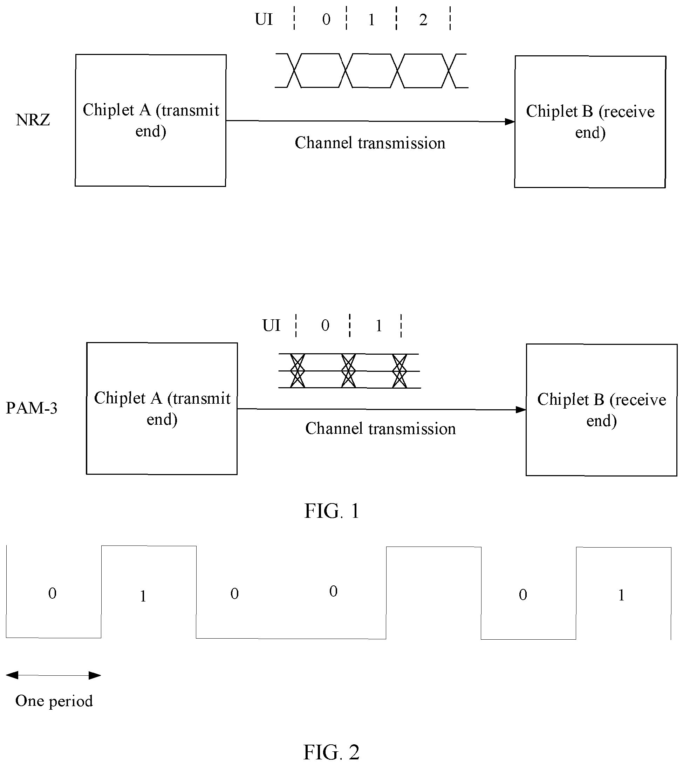

In a chiplet (Chiplet) interconnect system, chiplets can be interconnected through a plurality of channels for data transmission. For a fixed number of channels, increasing a rate of a single channel can increase an interconnection bandwidth. However, when a specific rate is reached, a further increase in the rate may reduce energy efficiency. If a multi-level encoding scheme is used in the channel, a signal transmission bandwidth can be increased without changing a baud rate. For example, FIG. 1 is a diagram depicting channel transmission using three-level pulse amplitude modulation (Pulse Amplitude Modulation-3, PAM-3) encoding and channel transmission using non-return-to-zero (Non-Return-to-Zero, NRZ) encoding. With NRZ encoding, 3-bit data transmission may be performed in a channel by using three unit intervals (Unit Interval, UI), while with PAM-3 encoding, 3-bit data transmission may be performed in a channel by using two UIs. Compared with NRZ encoding, PAM-3 encoding can make the interconnection bandwidth 1.5 times higher.

In the multi-level encoding scheme, when original bit errors of one UI occur in the channel, bit errors of a plurality of bits may occur after decoding. For example, for PAM-3 encoding, 3-bit data transmission is performed in a channel per two UIs. If original bit errors of one UI occur in the channel, bit errors of 2 to 3 bits may occur after decoding. Therefore, a receive end needs to perform error correction by using an error correction technique, so as to reduce a bit error rate of an interconnection interface.

However, in the conventional technology, error correction is generally performed by using a multi-bit error correction technique or a retransmission technique, and an error correction processing delay is large, affecting data transmission efficiency.

SUMMARY

This application provides a data transmission method, apparatus, and system, to reduce an error correction processing delay in a chiplet interconnect system, thereby improving data transmission efficiency.

According to a first aspect, a data transmission apparatus is provided. The apparatus may be a transmit end or the apparatus is located at a transmit end. The apparatus includes: an ECC encoder, configured to perform single-bit error correction ECC encoding on N groups of data bit streams to obtain N groups of ECC encoded bit streams, where each of the N groups of data bit streams includes M data bits, and encoded bits in each of the N groups of ECC encoded bit streams include M data bits and P check bits; an interleaver, configured to read encoded bits from the N groups of ECC encoded bit streams in a polling manner, and reassemble the encoded bits into a first encoded bit stream, where every N encoded bits in the first encoded bit stream are a unit, and N encoded bits in each unit are respectively from different ECC encoded bit streams; an IO data distributor, configured to distribute all units of the first encoded bit stream to Q IO pins, to obtain Q groups of IO data streams; PAM encoders, respectively configured to perform PAM-N encoding on the Q groups of IO data streams to obtain Q groups of PAM encoded bit streams; and the Q IO pins, respectively configured to send the Q groups of PAM encoded bit streams; where N, M, P, and Q are positive integers.

In this embodiment of this application, the transmit end performs single-bit ECC encoding on the N groups of data bit streams, and then interleaves the encoded N groups of ECC encoded bit streams, to ensure that N bits in one unit of the interleaved bit stream respectively correspond to different ECCs, and performs PAM encoding at a granularity of a unit. In this way, when bit errors occur in a unit, the errors are distributed to different ECCs, so that the receive end can complete multi-bit error correction processing in a single-bit error correction manner. Compared with a multi-bit error correction technique or a retransmission technique, the transmit end can provide a lower processing delay and smaller area power consumption.

In a possible implementation, the apparatus may further include a data packetizer, configured to packetize a raw data bit stream to obtain the N groups of data bit streams, and separately transmit the N groups of data bit streams to the ECC encoder.

In this manner, the raw data bit stream may be packetized into N groups of data bit streams, and the N groups of data bit streams are encoded by using different ECCs, thereby improving reliability of the solution.

In a possible implementation, all IO data streams in the Q groups of IO data streams have a same data length. In other words, the IO data distributor evenly distributes units of the first encoded bit stream to the Q IO pins.

In this manner, the parallelism of data processing can be improved, and data processing efficiency can be further improved.

In a possible implementation, the single-bit error correction ECC encoding includes extended Hamming codes for implementing SEC-DED, for example, optimal minimum odd-weight-column codes. Certainly, this is merely an example, and there may be other extended Hamming codes for implementing the SEC-DED.

In a possible implementation, a value of N is any one of 3, 4, 6, 8, or 16.

In this manner, single-bit ECC encoding can be implemented in PAM scenarios such as PAM-3, PAM-4, PAM-8, and PAM-16.

According to a second aspect, a data transmission apparatus is provided. The apparatus may be a receive end or the apparatus is located at a receive end. The apparatus includes: Q IO pins, respectively configured to receive Q groups of PAM encoded bit streams; a PAM decoder, configured to perform PAM-N decoding on the Q groups of PAM encoded bit streams to obtain Q groups of IO data streams; a first aggregator, configured to aggregate the Q groups of IO data streams to obtain a first encoded bit stream, where every N encoded bits in the first encoded bit stream are a unit; a de-interleaver, configured to read encoded bits from units of the first encoded bit stream, and reassemble the encoded bits into N groups of ECC encoded bit streams, where N encoded bits in each unit are respectively allocated to different ECC encoded bit streams, and encoded bits in each of the N groups of ECC encoded bit streams include M data bits and P check bits; and an ECC decoder, configured to perform single-bit error correction ECC decoding on the N groups of ECC encoded bit streams to obtain N groups of data bit streams; where N, M, P, and Q are positive integers.

In this embodiment of this application, the receive end performs PAM-N decoding on the Q groups of PAM encoded bit streams, and performs aggregation and interleaving processing on the decoded IO data streams, so that different encoded bits in a same unit are distributed to different ECCs. When bit errors occur in a unit, the errors are distributed to different ECCs, and the receive end can complete multi-bit error correction processing in a single-bit error correction manner. Compared with a multi-bit error correction technique or a retransmission technique, the receive end can provide a lower processing delay and smaller area power consumption.

In a possible implementation, the apparatus may further include: a second aggregator, configured to aggregate the N groups of data bit streams into a raw data bit stream.

In this implementation, the raw data bit stream can be restored, thereby improving reliability of the solution.

In a possible implementation, all IO data streams in the Q groups of IO data streams have a same data length.

In a possible implementation, the single-bit error correction ECC encoding includes extended Hamming codes for implementing SEC-DED, for example, optimal minimum odd-weight-column codes.

In a possible implementation, a value of N is any one of 3, 4, 6, 8, or 16.

According to a third aspect, a data transmission method is provided. The method includes: performing single-bit error correction ECC encoding on N groups of data bit streams to obtain N groups of ECC encoded bit streams, where each of the N groups of data bit streams includes M data bits, and encoded bits in each of the N groups of ECC encoded bit streams include M data bits and P check bits; reading encoded bits from the N groups of ECC encoded bit streams in a polling manner, and reassembling the encoded bits into a first encoded bit stream, where every N encoded bits in the first encoded bit stream are a unit, and N encoded bits in each unit are respectively from different ECC encoded bit streams; distributing all units of the first encoded bit stream to Q IO pins, to obtain Q groups of IO data streams; performing PAM-N encoding on the Q groups of IO data streams to obtain Q groups of PAM encoded bit streams; and sending the Q groups of PAM encoded bit streams through the Q IO pins; where N, M, P, and Q are positive integers.

In a possible implementation, the method further includes: packetizing a raw data bit stream to obtain the N groups of data bit streams.

In a possible implementation, all IO data streams in the Q groups of IO data streams have a same data length.

In a possible implementation, the single-bit error correction ECC encoding includes extended Hamming codes for implementing SEC-DED, for example, optimal minimum odd-weight-column codes.

In a possible implementation, a value of N is any one of 3, 4, 6, 8, or 16.

According to a fourth aspect, a data transmission method is provided. The method includes: receiving Q groups of PAM encoded bit streams through Q IO pins; performing PAM-N decoding on the Q groups of PAM encoded bit streams to obtain Q groups of IO data streams; aggregating the Q groups of IO data streams to obtain a first encoded bit stream, where every N encoded bits in the first encoded bit stream are a unit; reading encoded bits from units of the first encoded bit stream, and reassembling the encoded bits into N groups of ECC encoded bit streams, where N encoded bits in each unit are respectively allocated to different ECC encoded bit streams, and encoded bits in each of the N groups of ECC encoded bit streams include M data bits and P check bits; and performing single-bit error correction ECC decoding on the N groups of ECC encoded bit streams to obtain N groups of data bit streams; where N, M, P, and Q are positive integers.

In a possible implementation, the method further includes: aggregating the N groups of data bit streams into a raw data bit stream.

In a possible implementation, all IO data streams in the Q groups of IO data streams have a same data length.

In a possible implementation, the single-bit error correction ECC encoding includes extended Hamming codes for implementing SEC-DED, for example, optimal minimum odd-weight-column codes.

In a possible implementation, a value of N is any one of 3, 4, 6, 8, or 16.

According to a fifth aspect, a computer-readable storage medium is provided. The readable storage medium is configured to store instructions. When the instructions are executed, the method according to any one of the third aspect or the possible implementations of the third aspect is implemented, or the method according to any one of the fourth aspect or the possible implementations of the fourth aspect is implemented.

According to a sixth aspect, a computer program product is provided. The computer program product stores instructions. When the instructions are run on a computer, the method according to any one of the third aspect or the possible implementations of the third aspect is performed, or the method according to any one of the fourth aspect or the possible implementations of the fourth aspect is performed.

According to a seventh aspect, a data transmission system is provided, including the apparatus according to any one of the first aspect or the possible implementations of the first aspect and the apparatus according to any one of the second aspect or the possible implementations of the second aspect.

BRIEF DESCRIPTION OF DRAWINGS

FIG. 1 is a diagram depicting channel transmission using PAM-3 encoding and channel transmission using NRZ encoding;
FIG. 2 is a diagram of NRZ encoding;
FIG. 3A is a diagram of PAM-3 encoding;
FIG. 3B is a diagram depicting that an error of a single UI causes errors of a plurality of bits after PAM-3 decoding;
FIG. 4 is a diagram of an application scenario according to an embodiment of this application;
FIG. 5 is a diagram of a data transmission system according to an embodiment of this application;
FIG. 6A is a diagram of a data processing procedure in a data transmission apparatus 01;
FIG. 6B is a diagram of a data processing procedure in a data transmission apparatus 02;
FIG. 7 is a diagram of a data transmission apparatus 01 according to an embodiment of this application;
FIG. 8 is a diagram of data interleaving according to an embodiment of this application;
FIG. 9 is a diagram of IO data distribution according to an embodiment of this application;
FIG. 10 is a diagram of another data transmission apparatus 01 according to an embodiment of this application;
FIG. 11 is a diagram of another data transmission apparatus 01 according to an embodiment of this application;
FIG. 12 is a diagram of a specific data processing example;
FIG. 13 is a diagram of a data transmission apparatus 02 according to an embodiment of this application;
FIG. 14 is a diagram of IO data aggregation according to an embodiment of this application;
FIG. 15 is a diagram of data de-interleaving according to an embodiment of this application;
FIG. 16 is a diagram of another data transmission apparatus 02 according to an embodiment of this application;
FIG. 17 is a diagram of another data transmission apparatus 02 according to an embodiment of this application;
FIG. 18 is a diagram of a specific data processing example; and
FIG. 19 is a diagram of a specific example of single-bit error correction.

DESCRIPTION OF EMBODIMENTS

For ease of understanding the technical solutions in embodiments of this application, the following first describes some technical terms in this specification.

(1) Pulse amplitude modulation (Pulse Amplitude Modulation, PAM) is a modulation scheme in which an amplitude of a pulse carrier changes with a baseband signal. PAM is classified into a plurality of types based on modulation levels. For ease of description, in this specification, PAM-N may be used to represent N-level pulse amplitude modulation, where N is a positive integer. The level N may indicate a quantity of level values. For example, in PAM-3, there are three level values: high, medium, and low.

(2) Non-return-to-zero (Non-Return-to-Zero, NRZ) encoding, also referred to as two-level pulse amplitude modulation (Pulse Amplitude Modulation-2, PAM-2) encoding, is an encoding scheme in which two voltage levels are used to represent logic 0 and logic 1, for example, a high level represents 1 and a low level represents 0. Different from return-to-zero RZ (Return-to-zero) encoding, NRZ encoding does not need to return to zero. That is, an entire period can be used for data transmission. In this way, a transmission bandwidth can be fully used. Conventional digital signals usually use an NRZ signal. That is, two signal levels are used to represent information 1 and 0 of a digital logical signal, and transmission of 1-bit logical information may be performed per symbol period (or referred to as UI). For example, FIG. 2 is a diagram of NRZ encoding.

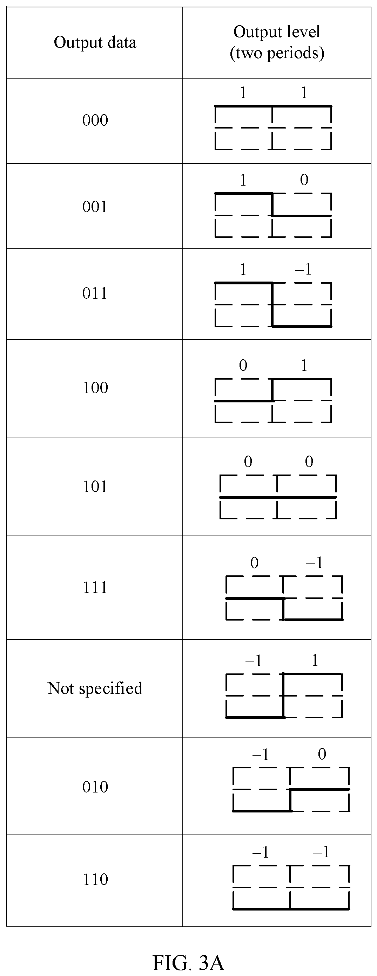

(3) Three-level pulse amplitude modulation (Pulse Amplitude Modulation-3, PAM-3) encoding: Two ternary level values are used to represent 3-bit logical information. That is, transmission of 3-bit logical information may be performed per two symbol periods. For example, FIG. 3A is a diagram of PAM-3 encoding. Three bits have eight combinations (that is, the cube of 2), and two level values have nine combinations (that is, the square of 3). The latter may cover the former. Therefore, two levels can represent 3-bit logical information, and each level actually includes 1.5-bit information.

Certainly, in addition to PAM-3 encoding, there are also multi-level PAM encoding schemes such as PAM-4 encoding, PAM-6 encoding, and PAM-8 encoding, which are not described one by one herein.

(4) A chiplet (Chiplet), also known as a chiplet or a small chip, is a pre-manufactured die (Die) that has specific functions and can be combined and integrated. Such type of dies (dies) satisfying specific functions are used to implement packaging of a plurality of modular chips onto a substrate chip by using a die-to-die (die-to-die) internal interconnect technology, so as to form a system-on-chip. Chiplets may be interconnected through a plurality of channels (a specific implementation of the channels may be an input/output (Input Output, IO or I/O) pin) for data transmission, thereby achieving low costs and a high yield while improving performance.

(5) The terms "system" and "network" may be used interchangeably in embodiments of this application. "At least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B may be singular or plural. The character "/" generally indicates an "or" relationship between the associated objects. "At least one of the following items" or a similar expression thereof means any combination of these items, including any combination of a single item or a plurality of items. For example, at least one item of a, b, or c may represent a, b, c, a and b, b and c, a and c, or a, b, and c.

In addition, unless otherwise stated, ordinal numbers such as "first" and "second" in embodiments of this application are for distinguishing between a plurality of objects, but are not intended to limit an order, a time sequence, priorities, or importance of the plurality of obj ects. For example, a first priority criterion and a second priority criterion are merely used to distinguish different criteria, and are not used to indicate different content, priorities, or importance degrees of the two types of criteria.

In addition, the terms "include" and "have" in embodiments of this application, the claims, and the accompanying drawings are not exclusive. For example, a process, a method, a system, a product, or a device that includes a series of steps or modules is not limited to the listed steps or modules, and may further include steps or modules that are not listed.

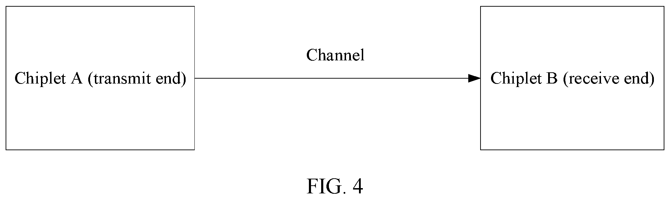

FIG. 4 is a diagram of an application scenario according to an embodiment of this application. The scenario illustrates a chiplet interconnect system, including at least two chiplets. It may be understood that FIG. 4 illustrates two chiplets, namely, a chiplet A and a chiplet B. However, the chiplets are not actually limited thereto. The chiplets may be interconnected through one or more channels for data transmission. For example, in FIG. 4, the chiplet A sends data to the chiplet B. That is, the chiplet A is a transmit end, and the chiplet B is a receive end.

It may be understood that an interconnection channel between chiplets is based on a channel inside a package, and can achieve a lower bit error rate than a chip-to-chip interconnection channel. It is generally defined in the industry that a bit error probability (Bit Error Rate, BER) before error correction is less than 1e-15. A transmission delay in the chiplet interconnect system affects overall performance of the system. When error correction is performed on a bit error, impact on the transmission delay should be reduced, and a bit error rate of interconnection transmission needs to be increased at a minimum implementation cost.

In the chiplet interconnect system, data may be encoded by using a multi-level encoding scheme, so as to increase a channel interconnection bandwidth. However, in the multi-level encoding scheme, if original bit errors of one UI occur in the channel, bit errors of a plurality of bits may occur after decoding. For example, for PAM-3 encoding, transmission of 3-bit data is performed in a channel per two UIs. If original bit errors of one UI occur in the channel, bit errors of 2 to 3 bits may occur after decoding.

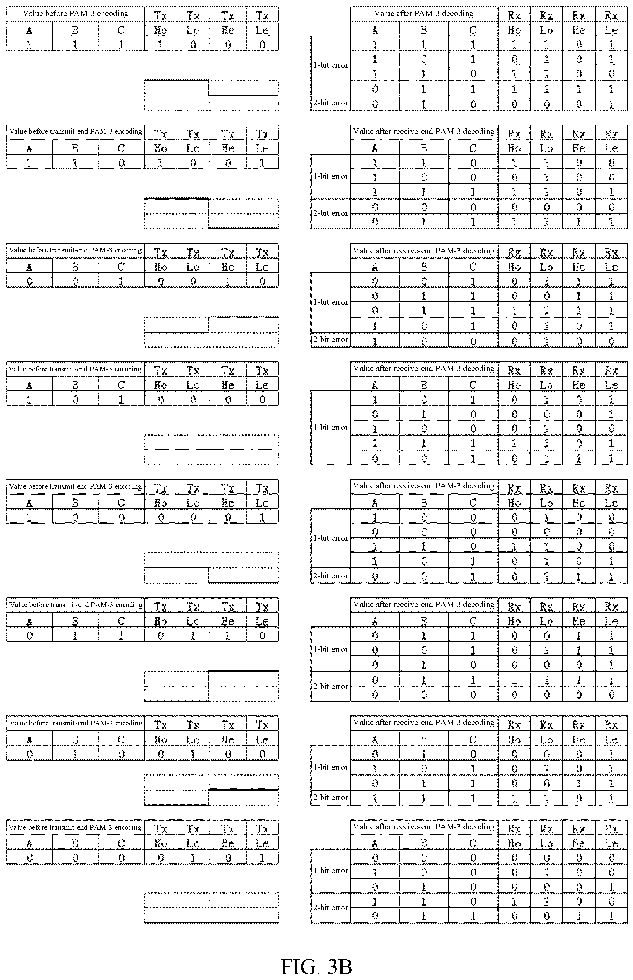

FIG. 3B is a diagram depicting that an error of a single UI causes errors of a plurality of bits after PAM-3 decoding. A receive end samples a level of each UI, where 00 indicates a low level (-1), 01 indicates an intermediate level (0), and 11 indicates a high level (1). Three data bits may be restored from levels of two consecutive UIs. For example, the raw data sent by a transmit end is 010, and the correct levels of the two UIs should be 00 (low level) and 01 (intermediate level). It is assumed that the level of the first UI is incorrectly sampled as the intermediate level 01; that is, the intermediate levels of the two UIs are received. In this case, the code pattern overlaps that for sending "101", and "101" is obtained through PAM-3 decoding, which has a 3-bit error compared with the correct "010" data.

Therefore, the receive end needs to perform error correction to reduce a bit error rate of an interconnection interface.

In an implementation, error detection and error correction may be performed on data in the chiplet interconnect system by using a Reed-Solomon code (Reed-Solomon, RS) (450, 406). In the RS encoding technique, 9 bits are used as a signal (symbol). Check bits of 44 symbols are added for the raw data of 406 symbols, supporting error correction of up to 22 symbol errors. At the transmit end, 45 81-bit data blocks and one piece of 9-bit operations, administration and maintenance (Operations Administration and Maintenance, OAM) information form 406 symbols. After RS(450, 406) encoding processing, 44 symbols are added, and data of 450 symbols is generated in total. At the receive end, after the data of 450 symbols undergoes RS(450, 406) decoding processing, the error-corrected raw data of 406 symbols is output, and the 45 81-bit data blocks and the one piece of 9-bit OAM are restored.

In this implementation, RS encoding and decoding processing is complex, resulting in a large processing delay (on the order of tens of ns), which cannot meet low-delay requirements of chiplet interface interconnection.

In another implementation, BCH codes (Bose-Chaudhuri-Hocquenghem codes) may be used to perform error detection and error correction on data in the chiplet interconnect system. BCH encoding is usually used to correct a plurality of random errors, and may be designed according to the number of bits to be corrected and a length of information bits. For a BCH(n,k,t) code, n is the codeword length, t is the number of error correcting bits, k is the number of information bits, $n=2^m-1$, and the check bits to be added are n-k=mt. The value of m is used to deduce check bits that need to be added to a primitive BCH code (a BCH code of code length n is referred to as a primitive BCH code) and a code length of a non-primitive BCH code (a BCH code whose code length is a factor is referred to as a non-primitive BCH code). For example, an instance of a primitive BCH code: BCH(8191, 7151, 80) indicates that a code length n=8191, information bits k=7151, and error-correctable bits t=80. If n, t, and the primitive BCH code are known, a process of deducing k may be as follows: Because $8191=2^{13}-1$, that is, m=13, the check bits that need to be added are n-k=mt=13*80=1040; and payload information bits are k=n-1040=8191-1040=7151. An instance of a non-primitive BCH code: BCH(9312, 8192, 80) indicates that a code length n=9312, information bits k=8192, and error-correctable bits t=80. If k, t, and the non-primitive BCH code are known, a process of deducing n is as follows: First, m is determined; because $k=8192=2^{**}13$, and generally, n-k<k and $n \leq 2^{**}m-1$, it can be deduced that m=14, and the check bits that need to be added are n-k=mt=14*80=1120; and payload information bits are n=k+1120=8192+1120=9312.

For a chiplet interconnect system based on PAM-3 encoding, at least 2-bit errors need to be corrected. For example, for BCH(255, 239, 2), 2 bits can be corrected, the number of information bits is 239, m=8, and check bits to be added are 255-239=8*2=16.

In this implementation, at least 2-bit errors need to be corrected, BCH decoding processing is complex, and a processing delay is still relatively large (on the order of ns).

In another implementation, after an error occurs in data transmission, error correction may be performed through data retransmission. At the transmit end, a sequence number and a cyclic redundancy check (Cyclic Redundancy Check, CRC) code are added to data, and the sent data is stored in a sending buffer. After receiving the data, the receive end performs a CRC check on data bits. When the data is correct, the receive end sends an acknowledgment (ACK) to the transmit end, and the transmit end releases the data in the sending buffer. When the data is erroneous, the receive end sends a negative acknowledgment (NACK) of the corresponding sequence number that also includes corresponding sequence number information to the transmit end, and the transmit end resends a packet corresponding to the sequence number.

In this implementation, each sent packet needs to be buffered, and the receive end needs to return ACK/NAK information in real time. In addition, a bidirectional link needs to be used, and transmission bandwidth of a reverse path is occupied, causing high implementation costs and power consumption. In addition, when the data is erroneous, the transmit end needs to perform retransmission to correct the error, and a processing delay is still relatively large.

It can be learned that, when error correction is performed by using a multi-bit error correction technique or a retransmission technique, a processing delay is large, and low-delay requirements of chiplet interface interconnection cannot be met.

In view of this, the technical solutions in embodiments of this application are provided, allowing error correction to be performed by using a single-bit error correction technique in a chiplet interconnect system. Compared with a multi-bit error correction technique or a retransmission technique, this application provides a lower delay and smaller area power consumption.

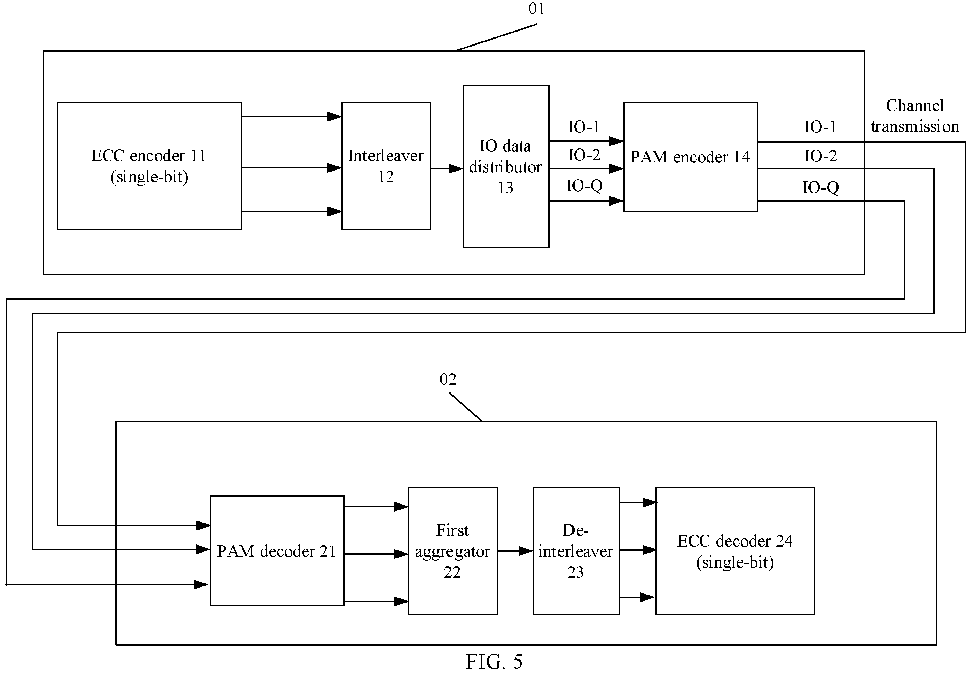

FIG. 5 is a diagram of a data transmission system according to an embodiment of this application. The system includes a data transmission apparatus 01 and a data transmission apparatus 02.

The data transmission apparatus 01 is a transmit end or an apparatus at the transmit end, for example, the chiplet A in the scenario shown in FIG. 4. The data transmission apparatus 01 includes an error-correcting code (Error-Correcting Codes, ECC) encoder 11, an interleaver 12, an IO data distributor 13, and a PAM encoder 14.

The data transmission apparatus 02 is a receive end or an apparatus at the receive end, for example, the chiplet B in the scenario shown in FIG. 4. The data transmission apparatus 02 includes a PAM decoder 21, a first aggregator 22, a de-interleaver 23, and an ECC decoder 24.

The data transmission system further includes a plurality of IO pins. Each IO pin includes a plurality of parts. One part is distributed in the data transmission apparatus 01, another part is distributed in the data transmission apparatus 02, and still another part is connected between the data transmission apparatus 01 and the data transmission apparatus 02 and is used as an interconnection channel between the data transmission apparatus 01 and the data transmission apparatus 02, for transmission of data sent by the data transmission apparatus 01 to the data transmission apparatus 02.

The data transmission apparatus 01 is configured to perform processing such as single-bit ECC encoding, interleaving, and encoding PAM-N on raw data, and then transmit a processed data stream to the data transmission apparatus 02 through the channel. The data transmission apparatus is configured to perform processing such as PAM-N decoding, de-interleaving, and single-bit ECC decoding on the received data, to restore the raw data.

The following describes a data processing solution in the data transmission apparatus 01.

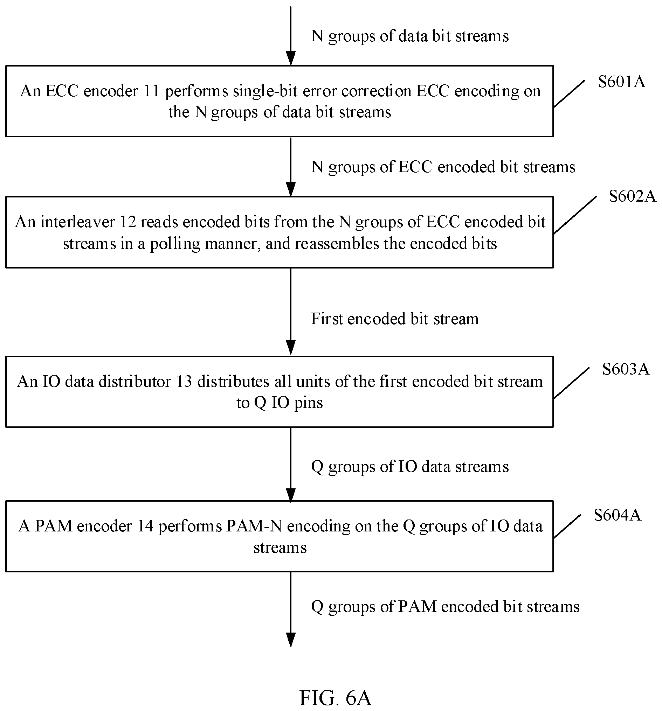

FIG. 6A is a diagram of a data processing procedure in a data transmission apparatus 01.

S601A: The ECC encoder 11 performs single-bit error correction ECC encoding on N groups of data bit streams to obtain N groups of ECC encoded bit streams.

A value of N is a positive integer greater than 2. For example, the value of N is any one of 3, 4, 6, 8, or 16.

Each of the N groups of data bit streams includes M data bits, and encoded bits in each of the N groups of ECC encoded bit streams include M data bits and P check bits.

It may be understood that the quantity of groups (that is, N) of the data bit streams in step S601A corresponds to an encoding scheme of the PAM encoder 14 in step S604A. For example, if the encoding scheme of the PAM encoder 14 is PAM-3 encoding, N=3; and if the encoding scheme of the PAM encoder 14 is PAM-4 encoding, N=4.

Optionally, the single-bit error correction ECC encoding includes extended Hamming codes for implementing single-error correction and double-error detection (Single-error correction and double-error detecting, SEC-DED). For example, optimal minimum odd-weight-column codes or other extended Hamming codes for implementing SEC-DED may be included. This is not limited in this application. Using an optimal minimum odd-weight-column code as an example, the encoding scheme is PAM-3 encoding. If each group of data bit stream includes 120 data bits, 8 check bits may be added to each group of data bit stream, and 128 bits are output for each group of ECC encoded bit stream.

In embodiments of this application, different ECC encoded bit streams (or data bit streams) correspond to different error-correcting codes, that is, ECCs (specifically, for example, optimal minimum odd-weight-column codes).

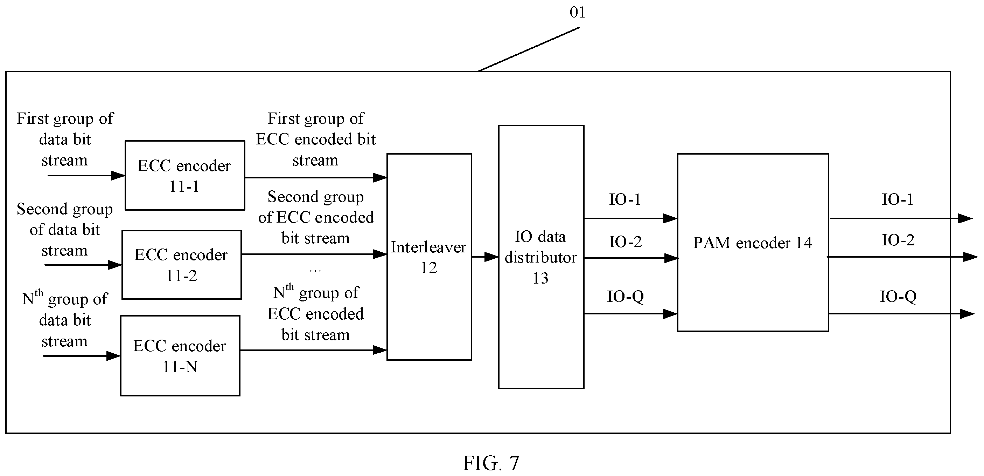

Optionally, there are N ECC encoders 11. As shown in FIG. 7, the N ECC encoders 11 are respectively configured to perform single-bit error correction ECC encoding on the N groups of data bit streams. Different ECC encoders 11 use different ECCs, so that different ECC encoded bit streams correspond to different ECCs. For example, an ECC encoder 11-1 is configured to perform single-bit error correction ECC encoding on a first group of data bit stream to obtain a first group of ECC encoded bit stream, an ECC encoder 11-2 is configured to perform single-bit error correction ECC encoding on a second group of data bit stream to obtain a second group of ECC encoded bit stream, ..., and an ECC encoder 11-N is configured to perform single-bit error correction ECC encoding on an N$^{th}$ group of data bit stream to obtain an N$^{th}$ group of ECC encoded bit stream.

S602A: The interleaver 12 reads encoded bits from the N groups of ECC encoded bit streams in a polling manner, and reassembles the encoded bits into a first encoded bit stream.

It may be understood that the interleaver 12 reading the encoded bits from the N groups of ECC encoded bit streams in a polling manner means performing a plurality of rounds of read operations on the N groups of ECC encoded bit streams. A process in which the interleaver 12 performs one read operation on each of the N groups of ECC encoded bit streams is one round. Specifically, the interleaver 12 reads 1-bit data from each of the N groups of ECC encoded bit streams in each round, that is, reads a total of N bits in each round, where the N bits are respectively from the N groups of ECC encoded bit streams. Upon completing a round of read operations, the interleaver 12 performs a next round of read operations until all the encoded bits in the N groups of ECC encoded bit streams have been read.

Optionally, the interleaver 12 reads the encoded bits from the N groups of ECC encoded bit streams in all rounds in a same order, and the order may be referred to as a first polling order. Using N=3 as an example, the first polling order is, for example, the first group of ECC encoded bit stream, the second group of ECC encoded bit stream, and the third group of ECC encoded bit stream. Certainly, this is merely an example and not a limitation.

Because the N bits read in each round are respectively from the N groups of ECC encoded bit streams, every N encoded bits in the first encoded bit stream may be used as a unit in the bit order, and the N encoded bits in each unit are respectively from different ECC encoded bit streams.

Using N=3 as an example, the first to third bits are a unit (the first to third bits are respectively from three groups of ECC encoded bit streams), the fourth to sixth bits are a unit (the fourth to sixth bits are respectively from three groups of ECC encoded bit streams), ..., and so on.

Further optionally, relative positions of the N encoded bits read by the interleaver 12 in each round in the ECC encoded bit stream to which the N encoded bits belong are the same.

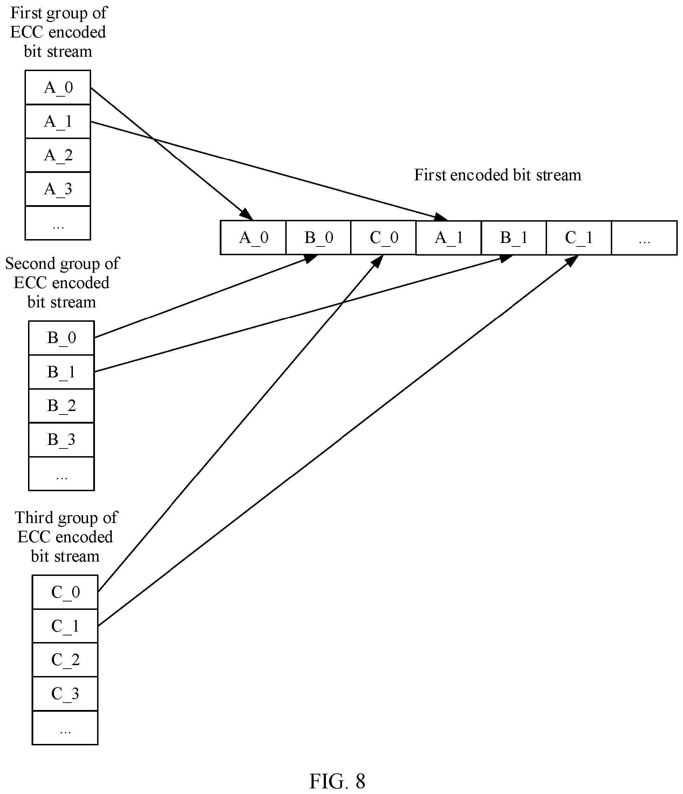

Refer to FIG. 8. For example, N=3, and the first polling order is the first group of ECC encoded bit stream, the second group of ECC encoded bit stream, and the third group of ECC encoded bit stream. The first group of ECC encoded bit stream is A_0/A_1/A_2..., the second group of ECC encoded bit stream is B_0/B_1/B_2..., and the third group of ECC encoded bit stream is C_0/C_1/C_2.... In the first round, the interleaver 12 sequentially reads the first bit (that is, A_0) in the first group of ECC encoded bit stream, the first bit (that is, B_0) in the second group of ECC encoded bit stream, and the first bit (that is, C_0) in the third group of ECC encoded bit stream. In the second round, the interleaver 12 sequentially reads the second bit (that is, A_1) in the first group of ECC encoded bit stream, the second bit (that is, B_1) in the second group of ECC encoded bit stream, and the second bit (that is, C_1) in the third group of ECC encoded bit stream, ..., and finally the first encoded bit stream A_0/B_0/C_0/A_1/B_1/C_1...A_N/B_N/C_N is obtained.

It may be understood that the process in which the interleaver reassembles the encoded bits read from the N groups of ECC encoded bit streams into the first encoded bit stream is essentially a process of rearranging the encoded bits. Therefore, the process may also be described as "interleaving".

S603A: The IO data distributor 13 distributes all units of the first encoded bit stream to Q IO pins, to obtain Q groups of IO data streams.

It may be understood that, the IO data distributor 13 distributes the bits in the first encoded bit stream at a granularity of a unit. In this way, it can be ensured that N bits (that is, N bits in each unit) distributed to the Q IO pins are from different ECC encoded bit data streams and respectively correspond to different ECCs.

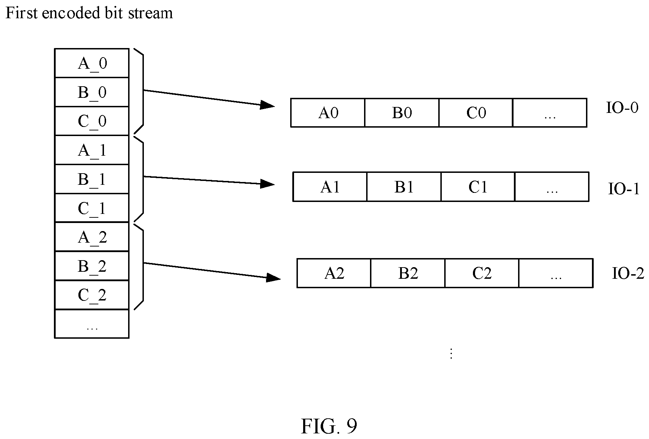

Continuing with the first encoded bit stream shown in FIG. 8, FIG. 9 is a diagram of distributing units of the first encoded bit stream to Q IO pins.

Optionally, the IO data distributor 13 evenly distributes the units of the first encoded bit stream to the Q IO pins. In other words, all IO data streams in the Q groups of IO data streams have a same data length. In this way, the parallelism of data processing can be improved, and data processing efficiency can be further improved.

S604A: The PAM encoder 14 performs PAM-N encoding on the Q groups of IO data streams to obtain Q groups of PAM encoded bit streams.

Specifically, the PAM encoder 14 performs encoding at a granularity of a unit. For example, N=3. Each unit includes 3 bits, which are respectively from three different ECC encoded data streams and respectively correspond to different ECCs. In the PAM-3 encoding scheme, the code of 3 bits of each unit may be represented by using two ternary level values. For a specific encoding principle, refer to related content shown in FIG. 3A. Details are not described herein again.

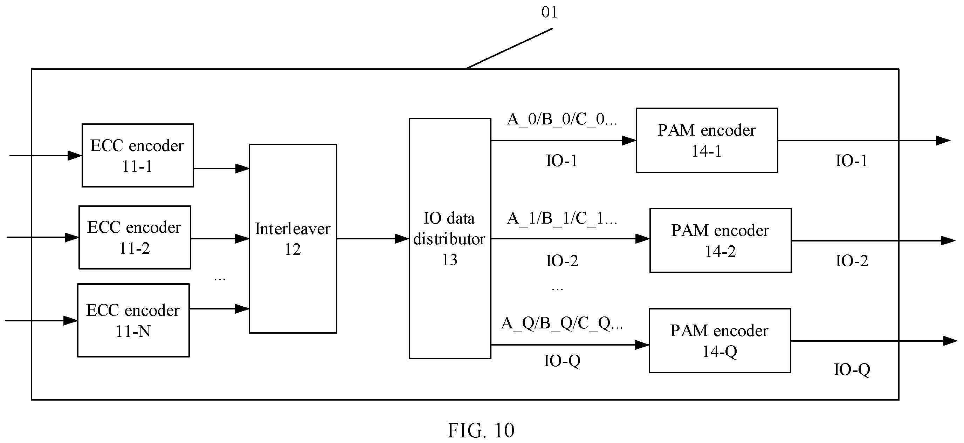

Optionally, as shown in FIG. 10, each IO pin corresponds to one PAM encoder 14. In other words, there are Q IO pins, and there are also Q PAM encoders 14. Each PAM encoder is configured to perform PAM-N encoding on an IO data stream on an IO pin corresponding to the PAM encoder.

Finally, the Q groups of PAM encoded bit streams are sent through the Q IO pins, respectively.

It may be understood that N, M, P, and Q are all positive integers.

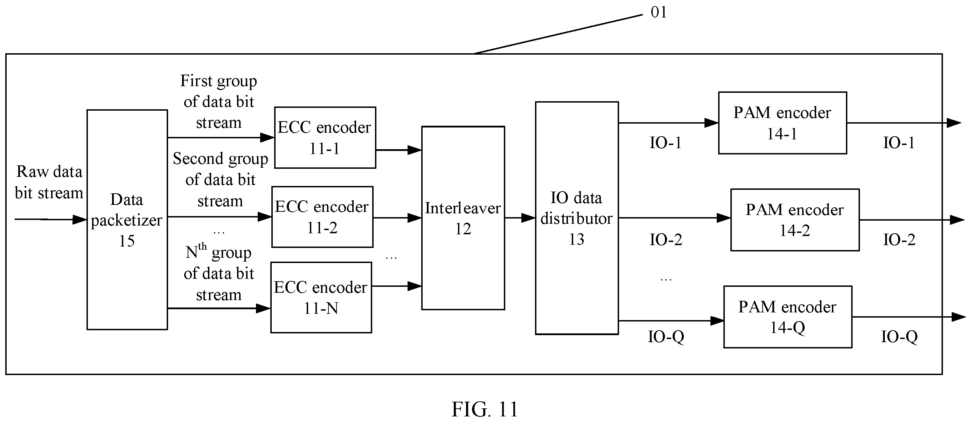

Optionally, as shown in FIG. 11, the data transmission apparatus 01 further includes a data packetizer 15, configured to packetize a raw data bit stream to obtain the N groups of data bit streams, and transmit the N groups of data bit streams to the ECC encoder 11.

To better understand the foregoing processing procedure, another complete example is provided herein.

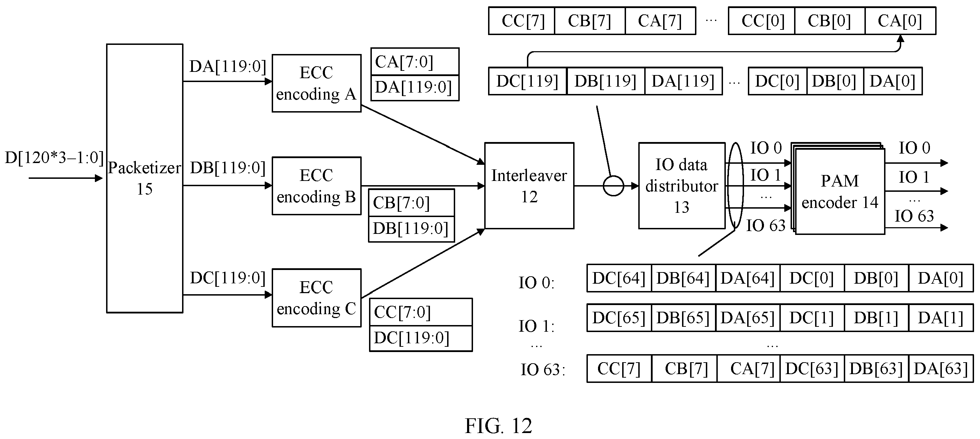

Using 120*3=360-bit raw data as an example, the data transmission apparatus 01 and the data transmission apparatus 02 are interconnected through 64 IO pins (that is, IO 0 to IO 63). Before sending data, the data transmission apparatus 01 needs to perform processing such as packetization, ECC encoding, interleaving, IO data distribution, and PAM-3 encoding on the raw data. Refer to FIG. 12. A specific processing procedure is as follows.

The data packetizer 15 evenly packetizes the 360-bit raw data (represented as D[120*3-1:0] in FIG. 12, which refers to data of 360 bits in total from 0 to 120*3-1) into three groups, with each group of 120 bits, and the three groups are DA[119:0], DB[119:0], and DC[119:0], respectively. Each group of data corresponds to one ECC encoder 11; that is, the three groups correspond to an ECC encoder A, an ECC encoder B, and an ECC encoder C, respectively.

Each ECC encoder 11 uses a minimum odd-weight-column code as an ECC encoding algorithm, adds 8-bit check bits (C[7:0]) to each group of input 120-bit data (D[119:0]), and outputs a total of 128-bit data. A calculation formula of the ECC encoding is {C[7:0], D[119:0]} = D[119:0] * G, where G is a 120*128-bit matrix, which is formed by a 120*120 identity matrix I2 and an 8*120 transpose matrix of H1, that is:

$$G = \begin{bmatrix} I2, & H1^T \end{bmatrix};$$

$$I2 = \begin{bmatrix} 1 & 0 & 0 & \cdots & 0 & 0 & 0 \\ 0 & 1 & 0 & \cdots & 0 & 0 & 0 \\ 0 & 0 & 1 & \cdots & 0 & 0 & 0 \\ 0 & 0 & 0 & \cdots & 0 & 0 & 0 \\ 0 & 0 & 0 & \cdots & 1 & 0 & 0 \\ 0 & 0 & 0 & \cdots & 0 & 1 & 0 \\ 0 & 0 & 0 & \cdots & 0 & 0 & 1 \end{bmatrix};$$

$$H1^T = \begin{bmatrix} 120' & \text{hfe6b9d\_d6} & \text{bad756\_daf} & \text{ffff8\_0000} & 0000 \\ 120' & \text{hfd5f3a\_bb} & \text{56cdb9\_d6f} & \text{c0007\_fff0} & 0000 \\ 120' & \text{hfbcdd7\_35} & \text{adaeae\_b68} & \text{3e007\_c00f} & \text{fc00} \\ 120' & \text{hf7b6af\_56} & \text{d5b9d5\_b54} & \text{21e04\_3c0f} & \text{03f0} \\ 120\text{hefad69} & \text{\_ed6b5f3 5\_} & \text{ad2111c2\_2} & \text{388e38e} \\ 120\text{hdfd2f2} & \text{\_eaeeb56 e\_} & \text{6d108931\_1} & \text{2649a6d} \\ 120' & \text{hbf7acc\_dd} & \text{756aeb\_6b0} & \text{844a8\_8952} & \text{555b} \\ 120 * & \text{h7fb577\_2b} & \text{9b72db\_5b0} & \text{42258\_44b1} & \text{2cb7} \end{bmatrix}.$$

The interleaver 12 reassembles the three groups of 128-bit data ({CC[7:0],DC[119:0]}, {CB[7:0],DB[119:0]}, {CA [7:0],DA[119:0]}) output by the three ECC encoders 11 into one group of parallel data, that is, the first encoded bit stream. A specific interleaving method is polling three groups of data, and one bit is taken from each of the groups at a time. Therefore, the finally output data is: CC[7],CB[7],CA[7],...,CC[0],CB[0],CA[0],DC[119],DB[119],DA[119],...,DC[1],DB [1],DA[1], DC[0],DB[0],DA[0].

The IO data distributor 13 sequentially distributes the interleaved data to the 64 IO pins in the bit order in a unit of 3 consecutive bits, where 6-bit IO data is transmitted to each IO pin.

For example,

IO 0: DC[64],DB[64],DA[64], DC[0],DB[0],DA[0];
IO 1: DC[65],DB[65],DA[65], DC[0],DB[0],DA[0]; ...
IO 63: CC[7],CB[7],CA[7],DC[63],DB[63],DA[63].

It may be understood that the foregoing distribution manner is merely an example and not a specific limitation.

The PAM-3 encoder 14 performs PAM-3 encoding on data in each IO pin, so that transmission of three data bits is performed by using two UIs, thereby obtaining 64 groups of PAM encoded bit streams, each of which includes four bits.

It should be noted that the foregoing describes only several key components in the data transmission apparatus 01 and the method performed by the key components. In actual application, the data transmission apparatus 01 may further include other components. Before sending data, the data transmission apparatus 01 may further perform other processing on the data. For example, before performing the PAM encoding, the data transmission apparatus 01 may further perform processing such as scrambling and repair on data before the PAM encoding; and after performing the PAM encoding, the data transmission apparatus 01 may further perform parallel-to-serial processing on data after the PAM encoding. This is not limited in this application.

In addition, in actual application, the positions of some components in the data transmission apparatus 01 may also be swapped. For example, the IO data distributor 13 may also be arranged after the PAM encoder 14. To be specific, the data transmission apparatus 01 may first perform PAM-N encoding on the first encoded bit stream, and then perform IO distribution on PAM-N encoded data.

The following describes a data processing solution in the receive end (that is, the data transmission apparatus 02).

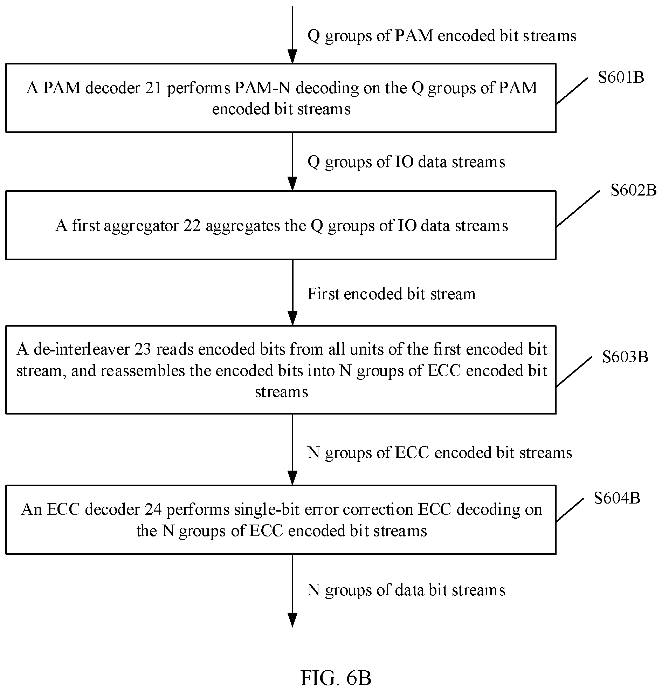

FIG. 6B is a diagram of a data processing procedure in a data transmission apparatus 02.

S601B: The PAM decoder 21 performs PAM-N decoding on Q groups of PAM encoded bit streams to obtain Q groups of IO data streams.

Specifically, the PAM decoder 21 obtains the Q groups of PAM encoded bit streams from the Q IO pins. The Q groups of PAM encoded bit streams are sent by the data transmission apparatus 01 to the Q IO pins.

S601B is a process opposite to S604A. A decoding scheme of the PAM decoder 21 corresponds to the encoding scheme of the PAM encoder 14 in the data transmission apparatus 01. A value of N is a positive integer greater than 2. For example, the value of N is any one of 3, 4, 6, 8, or 16. For example, if the encoding scheme of the PAM encoder 14 is PAM-3 encoding, the decoding scheme of the PAM decoder 21 is PAM-3 decoding; that is, level values of every two UIs in a PAM encoded bit stream are decoded into 3-bit data. For a specific decoding principle, refer to related content shown in FIG. 3A. Details are not described herein again.

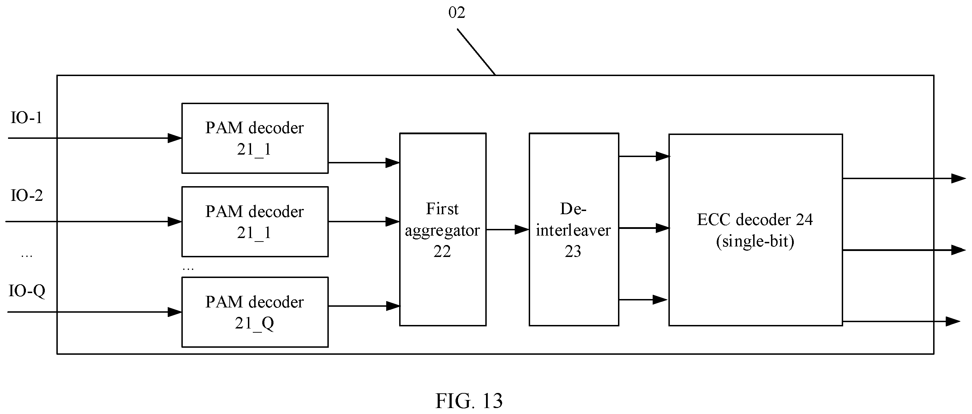

Optionally, as shown in FIG. 13, each IO pin corresponds to one PAM decoder 21. There are Q IO pins, and there are also Q PAM decoders 21. Each PAM decoder is configured to perform PAM-N decoding on an IO data stream on an IO pin corresponding to the PAM decoder.

Optionally, each of the Q groups of PAM encoded bit streams has a same length.

S602B: The first aggregator 22 aggregates the Q groups of IO data streams to obtain a first encoded bit stream, where every N encoded bits in the first encoded bit stream are a unit.

S602B is a process opposite to S603A. Specifically, the first aggregator 22 may sequentially reassemble units of the Q groups of IO data streams into the first encoded bit stream by using every N consecutive encoded bits in each of the Q groups of IO data streams as a unit.

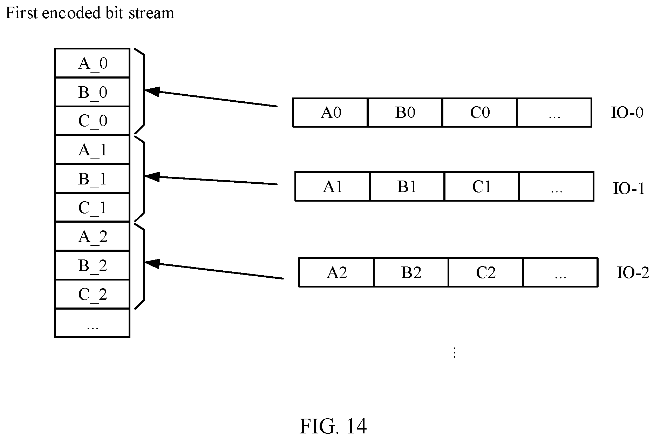

It may be understood that the order in which the first aggregator 22 reassembles the units herein corresponds to the order in which the IO data distributor 13 in the data transmission apparatus 01 distributes the units. For example, when the order in which the IO data distributor 13 distributes the units of the first encoded bit stream to the Q IO pins is the order shown in FIG. 9, the order in which the first aggregator 22 reassembles the units of the Q groups of IO data streams into the first encoded bit stream is the order shown in FIG. 14. In this way, it is ensured that the bit order of the first encoded bit stream output by the first aggregator 22 is the same as the bit order of the first encoded bit stream input by the IO data distributor 13. Using N=3 as an example, the first to third bits in the first encoded bit stream are a unit, the fourth to sixth bits are a unit, ..., and so on.

It may be understood that the order in which the first aggregator 22 reassembles the units and the order in which the IO data distributor 13 distributes the units may be specified in a protocol, or may be configured by another control apparatus, or may be agreed on in advance by the data transmission apparatus 01 and the data transmission apparatus 02, or may be configured by the data transmission apparatus 01 and notified to the data transmission apparatus 02, or may be configured by the data transmission apparatus 02 and notified to the data transmission apparatus 01, or the like. This is not limited in this application.

S603B: The de-interleaver 23 reads encoded bits from the units of the first encoded bit stream, and reassembles the encoded bits into N groups of ECC encoded bit streams.

S603B is a process opposite to S602A, and the process may be referred to as "de-interleaving".

It may be understood that, to correspond to S602A and facilitate understanding, the process in which the de-interleaver 23 reads the encoded bits from the units of the first encoded bit stream may also be described herein in a polling manner. A process in which the de-interleaver 23 reads one unit of the first encoded bit stream and allocates bits in the unit to the ECC encoded bit streams is one round. Specifically, the de-interleaver 12 reads one unit, that is, N consecutive bits, from the first encoded bit stream in each round, and then allocates the N bits to the N groups of ECC encoded bit streams in the reading order. Upon completing one round of reading and allocation operations, the de-interleaver 23 performs a next round of reading and allocation operations until all the units of the first encoded bit stream have been read and allocated.

Using N=3 as an example, the first to third bits in the first encoded bit stream are a unit, and the first to third bits are respectively allocated to three different groups of ECC encoded bit streams; the fourth to sixth bits in the first encoded bit stream are a unit, and the fourth to sixth bits are respectively allocated to three different groups of ECC encoded bit streams, ..., and so on, until all the encoded bits in the first encoded bit stream have been allocated, to obtain the N groups of ECC encoded bit streams.

Correspondingly, encoded bits in each of the N groups of ECC encoded bit streams include M data bits and P check bits.

Optionally, the de-interleaver 23 reads and allocates the encoded bits in the same order in each round, and the order may be referred to as a second polling order. It may be understood that the second polling order herein corresponds to the foregoing first polling order (that is, the order in which the interleaver 12 reads the encoded bits from the N groups of ECC encoded bit streams in each round). For example, N=3 is used as an example. For example, if the first polling order is the first group of ECC encoded bit stream, the second group of ECC encoded bit stream, and the third group of ECC encoded bit stream, the second polling order is correspondingly the first encoded bit (allocated to the first group of ECC encoded bit stream), the second encoded bit (allocated to the second group of ECC encoded bit stream), and the third encoded bit (allocated to the third group of ECC encoded bit stream) in each unit.

Further optionally, relative positions of the encoded bits read by the de-interleaver 23 in each round in the ECC encoded bit stream to which the encoded bits are allocated are the same.

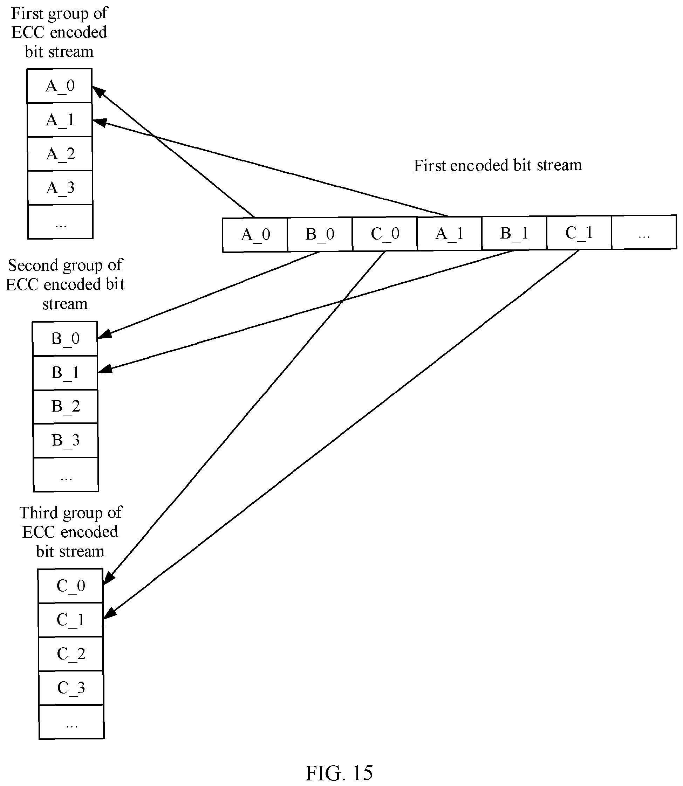

Refer to FIG. 15. For example, N=3, and the second polling order is the first encoded bit, the second encoded bit, and the third encoded bit in each unit. In the first round, the de-interleaver 23 reads the first unit (that is, the first to third bits) of the first encoded bit stream, and allocates the first bit (that is, A_0) in the first unit to the first group of ECC encoded bit stream, the second bit (that is, B_0) in the first unit to the second group of ECC encoded bit stream, and the third bit (that is, C_0) in the first unit to the third group of ECC encoded bit stream. In the second round, the de-interleaver 23 reads the second unit (that is, the fourth to sixth bits) in the first encoded bit stream, and allocates the first bit (that is, A_1) in the second unit to the first group of ECC encoded bit stream, the second bit (that is, B_1) in the second unit to the second group of ECC encoded bit stream, and the third bit (that is, C_1) in the second unit to the third group of ECC encoded bit stream, ..., and so on. The finally obtained three groups of ECC encoded bit streams are: A_0/A_1/A_2..., B_0/B_1/B_2..., and C_0/C_1/C_2..., respectively.

S604B: The ECC decoder 24 performs single-bit error correction ECC decoding on the N groups of ECC encoded bit streams to obtain N groups of data bit streams.

S604B is a process opposite to S601A. The ECC decoding scheme used by the ECC decoder 24 corresponds to the ECC encoding scheme used by the ECC encoder 11 in the data transmission apparatus 01. The ECC is specifically, for example, optimal minimum odd-weight-column codes or other extended Hamming codes for implementing SEC-DED. This is not limited in this application. The ECC encoding and decoding schemes may be specifically specified in a protocol, or may be configured by another control apparatus, or may be agreed on in advance by the data transmission apparatus 01 and the data transmission apparatus 02, or may be configured by the data transmission apparatus 01 and notified to the data transmission apparatus 02, or may be configured by the data transmission apparatus 02 and notified to the data transmission apparatus 01, or the like. This is not limited in this application.

Because the N bits in each unit correspond to different ECCs, when multi-bit errors occur in a unit, the errors are distributed to different ECCs, so that the multi-bit errors can be corrected based on a single-bit error correction technique.

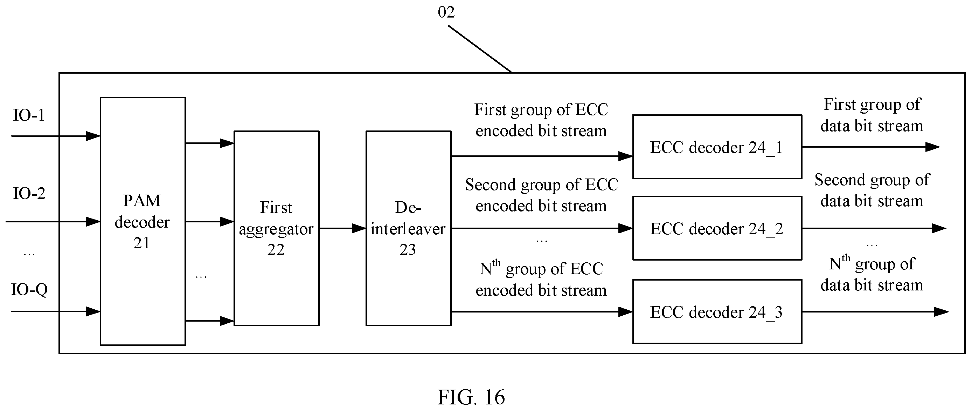

Optionally, there are N ECC decoders 24. As shown in FIG. 16, the N decoders 24 are respectively configured to perform single-bit error correction ECC decoding on the N groups of ECC encoded bit streams. The different N decoders 24 correspond to different ECCs. For example, an ECC decoder 24-1 is configured to perform single-bit error correction ECC decoding on the first group of ECC encoded bit stream to obtain a first group of data bit stream, an ECC decoder 24-2 is configured to perform single-bit error correction ECC decoding on the second group of ECC encoded bit stream to obtain a second group of data bit stream, ..., and an ECC decoder 24-N is configured to perform single-bit error correction ECC decoding on the $N^{th}$ group of ECC encoded bit stream to obtain an $N^{th}$ group of data bit stream.

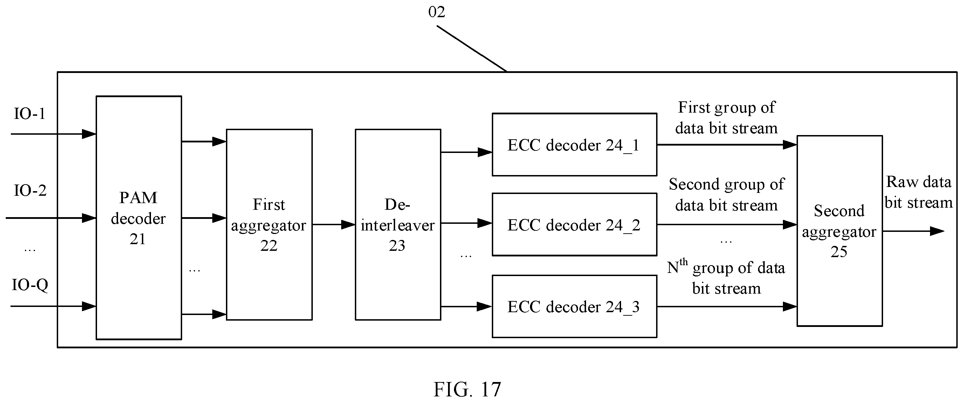

Optionally, as shown in FIG. 17, the data transmission apparatus 02 further includes a second aggregator 25, configured to aggregate the N groups of data bit streams to obtain a raw data bit stream.

To better understand the foregoing processing procedure, another complete example is provided herein.

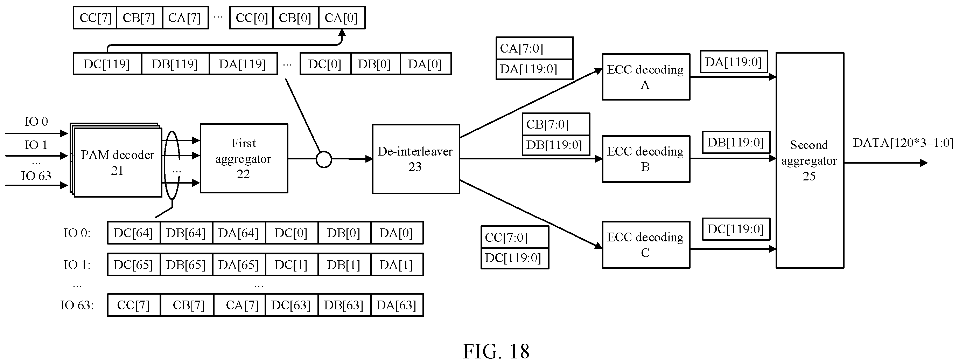

Continuing with the example of FIG. 12, the raw data has 120*3=360 bits, and the data transmission apparatus 01 and the data transmission apparatus 02 are interconnected through 64 IO pins (that is, IO 0 to IO 63). The data transmission apparatus 01 outputs 64 groups of PAM encoded bit streams. After receiving the 64 groups of PAM encoded bit streams, the data transmission apparatus 02 performs processing such as PAM-3 decoding, IO data aggregation, de-interleaving, and ECC decoding. Refer to FIG. 18. A specific processing procedure is as follows.

The PAM decoder 21 performs PAM-3 decoding on the 64 groups of PAM encoded bit streams. The PAM-3 decoding implements restoring of three data bits from the received data of two UIs of each IO, to obtain 64 groups of IO data streams:

IO 0: DC[64],DB[64],DA[64], DC[0],DB[0],DA[0];
IO 1: DC[65],DB[65],DA[65], DC[0],DB[0],DA[0]; ...
IO 63: CC[7],CB[7],CA[7],DC[63],DB[63],DA[63].

The first aggregator 22 packetizes the 64 groups of IO data streams into one group of data stream. Specifically, using 3 consecutive bits as a unit, 3-bit data is sequentially taken from IO 0 to IO 63 in the IO order, to finally form 384-bit data: CC[7],CB[7],CA[7],...,CC[0],CB[0],CA[0],DC[119],DB[119],DA[119],...,DC[1],DB[1],DA[1], DC[0],DB[0],DA[0].

The de-interleaver 23 divides the data output by the first aggregator 22 into three groups of 128-bit data. Specifically, in the bit order, one bit is taken at a time in a unit of 3 bits, to form three groups of data {CC[7:0],DC[119:0]}, {CB[7:0],DB[119:0]}, {CA[7:0],DA[119:0]}.

The 128-bit data {C[7:0], D[119:0]} received by each of the ECC decoders A, B, and C includes 120-bit data and 8-bit check bits. Each ECC decoder calculates the syndrome S to determine whether error correction needs to be performed on the received D[119:0] data.

$$S=\{C[7:0],D[119:0]\}*HT;$$

where H is 8*128 bits and is formed by an 8x120-bit H1 matrix and an 8x8-bit identity matrix I1:

$$H = \begin{bmatrix} H1, & HI1 \end{bmatrix};$$

$$H1 = \begin{bmatrix} 120'hfe6b9d\_d6bad756\_dafffff8\_00000000 \\ 120'hfd5f3a\_bb56cdb9\_d6fc0007\_fff00000 \\ 120'hfbcdd7\_35adaeae\_b683e007\_c00ffc00 \\ 120'hf7b6af\_56d5b9d5\_b5421e04\_3c0f03f0 \\ 120hefad69\_ed6b5f35\_ad2111c2\_2388e38e \\ 120hdfd2f2\_eaeeb56e\_6d108931\_12649a6d \\ 120'hbf7acc\_dd756aeb\_6b0844a8\_8952555b \\ 120*h7fb577\_2b9b72db\_5b042258\_44b12cb7 \end{bmatrix};$$

$$I1 = \begin{bmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \end{bmatrix}.$$

S has 8 bits. When S is 0, it indicates that no error occurs, and D[119:0] is directly output as the decoded data. When S is not 0 and is equal to a value of a column in the H check matrix, it indicates that an error occurs in a bit corresponding to the column, and the bit is inverted to restore the raw data. After the ECC decoding, the corrected 120-bit data D[119:0] is output.

The second aggregator 25 aggregates the three groups of corrected 120-bit data into 360-bit data, forming the 360-bit raw data in order, that is, D[120*3-1:0] = {DC[119:0], DB[119:0], DA[119:0]}.

It should be noted that the foregoing describes only several key components in the data transmission apparatus 02 and the method performed by the key components. In actual application, the data transmission apparatus 02 may further include other components. The data transmission apparatus 02 may further perform other processing on the data. For example, before performing the PAM decoding, the data transmission apparatus 02 may further perform serial-to-parallel processing on data before the PAM decoding; and after the PAM decoding, the data transmission apparatus 02 may further perform processing such as repair and descrambling on the decoded data. This is not limited in this application.

In addition, in actual application, the positions of some components in the data transmission apparatus 02 may also be swapped. For example, the first aggregator 22 may also be arranged before the PAM decoder 21. To be specific, the data transmission apparatus 02 may first aggregate the data of the IO pins, and then perform PAM-N decoding on the aggregated data.

Optionally, the foregoing Q IO pins belong to a same lane, where the lane is a set of all physical layer pins that share a same forward clock source. In other words, the method described above is an example of data transmission on one lane. However, in actual application, the data transmission apparatus 01 and the data transmission apparatus 02 may perform transmission on a plurality of lanes at the same time, so as to increase a total bit width of the entire transmission interface. It may be understood that, in the case of transmission on a plurality of lanes, for a data processing procedure corresponding to each lane, refer to the foregoing method procedure.

In this embodiment of this application, the transmit end performs single-bit ECC encoding on the N groups of data bit streams, and then interleaves the encoded N groups of ECC encoded bit streams, to ensure that N bits in one unit of the interleaved bit stream respectively correspond to different ECCs, and performs PAM encoding at a granularity of a unit. In this way, when bit errors occur in a unit, the errors are distributed to different ECCs, so that the receive end can complete multi-bit error correction processing in a single-bit error correction manner.

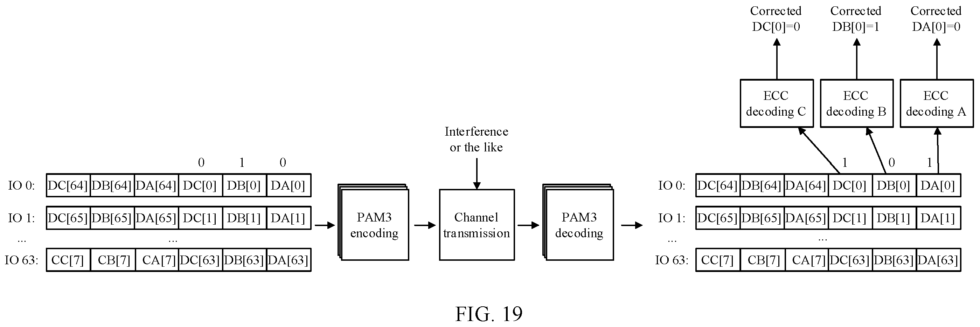

For example, FIG. 19 is a diagram of error correction. It is assumed that an error occurs in one UI of IO_0 due to external interference, and all the other UIs and IOs are normal. For example, "010" is sent, and the receive end obtains "101" after PAM-3 decoding. However, the three bits correspond to ECCs respectively, and each ECC can correct a 1-bit error. Therefore, after the ECC decoding, the three bits are corrected to "010", so that a 3-bit error correcting capability is achieved in a single-bit error correction manner.

It can be learned that, in this embodiment of this application, error correction is performed by using a single-bit error correction technique in a chiplet interconnect system. Compared with a multi-bit error correction technique or a retransmission technique, this application can provide a lower delay and smaller area power consumption.

Based on a same technical concept, an embodiment of this application further provides a computer-readable storage medium. The readable storage medium is configured to store instructions. When the instructions are executed, the method shown in FIG. 6A or FIG. 6B is implemented.

Based on a same technical concept, an embodiment of this application further provides a computer program product. The computer program product stores instructions. When the instructions are run on a computer, the method shown in FIG. 6A or FIG. 6B is performed.

A person skilled in the art should understand that the embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

The computer program instructions may alternatively be loaded onto a computer or another programmable data processing device, so that a series of operations and steps are performed on the computer or the another programmable device, so that computer-implemented processing is generated. Therefore, the instructions executed on the computer or the another programmable device provide steps for implementing a specific function in one or more procedures in the flowcharts and/or in one or more blocks in the block diagrams.

It is clear that a person skilled in the art can make various modifications and variations to this application without departing from the scope of this application. This application is intended to cover these modifications and variations of this application provided that they fall within the scope of protection defined by the following claims and their equivalent technologies.

**Claims**

1. A data transmission apparatus, comprising:

    an error-correcting code ECC encoder, configured to perform single-bit error correction ECC encoding on N groups of data bit streams to obtain N groups of ECC encoded bit streams, wherein each of the N groups of data bit streams comprises M data bits, and encoded bits in each of the N groups of ECC encoded bit streams comprise M data bits and P check bits;
    an interleaver, configured to read encoded bits from the N groups of ECC encoded bit streams in a polling manner, and reassemble the encoded bits into a first encoded bit stream, wherein every N encoded bits in the first encoded bit stream are a unit, and N encoded bits in each unit are respectively from different ECC encoded bit streams;
    an input/output IO data distributor, configured to distribute all units of the first encoded bit stream to Q IO pins, to obtain Q groups of IO data streams;

a pulse amplitude modulation PAM encoder, configured to perform PAM-N encoding on the Q groups of IO data streams to obtain Q groups of PAM encoded bit streams; and

the Q IO pins, respectively configured to send the Q groups of PAM encoded bit streams; wherein

N, M, P, and Q are positive integers.

2. The apparatus according to claim 1, wherein the apparatus further comprises:
a data packetizer, configured to packetize a raw data bit stream to obtain the N groups of data bit streams, and separately transmit the N groups of data bit streams to the ECC encoder.

3. The apparatus according to claim 1 or 2, wherein all IO data streams in the Q groups of IO data streams have a same data length.

4. The apparatus according to any one of claims 1 to 3, wherein the single-bit error correction ECC encoding comprises extended Hamming codes for implementing single-error correction and double-error detection SEC-DED.

5. The apparatus according to claim 4, wherein the extended Hamming codes for implementing SEC-DED comprise optimal minimum odd-weight-column codes.

6. The apparatus according to any one of claims 1 to 5, wherein a value of N is any one of 3, 4, 6, 8, or 16.

7. A data transmission apparatus, comprising:

Q IO pins, respectively configured to receive Q groups of PAM encoded bit streams;

a PAM decoder, configured to perform PAM-N decoding on the Q groups of PAM encoded bit streams to obtain Q groups of IO data streams;

a first aggregator, configured to aggregate the Q groups of IO data streams to obtain a first encoded bit stream, wherein every N encoded bits in the first encoded bit stream are a unit;

a de-interleaver, configured to read encoded bits from units of the first encoded bit stream, and reassemble the encoded bits into N groups of ECC encoded bit streams, wherein N encoded bits in each unit are respectively allocated to different ECC encoded bit streams, and encoded bits in each of the N groups of ECC encoded bit streams comprise M data bits and P check bits; and

an ECC decoder, configured to perform single-bit error correction ECC decoding on the N groups of ECC encoded bit streams to obtain N groups of data bit streams; wherein

N, M, P, and Q are positive integers.

8. The apparatus according to claim 7, wherein the apparatus further comprises:
a second aggregator, configured to aggregate the N groups of data bit streams into a raw data bit stream.

9. The apparatus according to claim 7 or 8, wherein all IO data streams in the Q groups of IO data streams have a same data length.

10. The apparatus according to any one of claims 7 to 9, wherein the single-bit error correction ECC encoding comprises extended Hamming codes for implementing SEC-DED.

11. The apparatus according to claim 10, wherein the extended Hamming codes for implementing SEC-DED comprise optimal minimum odd-weight-column codes.

12. The apparatus according to any one of claims 7 to 11, wherein a value of N is any one of 3, 4, 6, 8, or 16.

13. A data transmission method, comprising:

performing single-bit error correction ECC encoding on N groups of data bit streams to obtain N groups of ECC encoded bit streams, wherein each of the N groups of data bit streams comprises M data bits, and encoded bits in each of the N groups of ECC encoded bit streams comprise M data bits and P check bits;

reading encoded bits from the N groups of ECC encoded bit streams in a polling manner, and reassembling the encoded bits into a first encoded bit stream, wherein every N encoded bits in the first encoded bit stream are a unit, and N encoded bits in each unit are respectively from different ECC encoded bit streams;

distributing all units of the first encoded bit stream to Q IO pins, to obtain Q groups of IO data streams;

performing PAM-N encoding on the Q groups of IO data streams to obtain Q groups of PAM encoded bit streams; and

sending the Q groups of PAM encoded bit streams through the Q IO pins; wherein

N, M, P, and Q are positive integers.

14. The method according to claim 13, wherein the method further comprises:
packetizing a raw data bit stream to obtain the N groups of data bit streams.

15. The method according to claim 13 or 14, wherein all IO data streams in the Q groups of IO data streams have a same data length.

16. The method according to any one of claims 13 to 15, wherein the single-bit error correction ECC encoding comprises extended Hamming codes for implementing SEC-DED.

17. The method according to claim 14, wherein the extended Hamming codes for implementing SEC-DED comprise optimal minimum odd-weight-column codes.

18. The method according to any one of claims 13 to 17, wherein a value of N is any one of 3, 4, 6, 8, or 16.

19. A data transmission method, comprising:

receiving Q groups of PAM encoded bit streams through Q IO pins;

performing PAM-N decoding on the Q groups of PAM encoded bit streams to obtain Q groups of IO data streams;

aggregating the Q groups of IO data streams to obtain a first encoded bit stream, wherein every N encoded bits in the first encoded bit stream are a unit;

reading encoded bits from units of the first encoded bit stream, and reassembling the encoded bits into N groups of ECC encoded bit streams, wherein N encoded bits in each unit are respectively allocated to different ECC encoded bit streams, and encoded bits in each of the N groups of ECC encoded bit streams comprise M data bits and P check bits; and

performing single-bit error correction ECC decoding on the N groups of ECC encoded bit streams to obtain N groups of data bit streams; wherein

N, M, P, and Q are positive integers.

20. The method according to claim 19, wherein the method further comprises:
aggregating the N groups of data bit streams into a raw data bit stream.

21. The method according to claim 19 or 20, wherein all IO data streams in the Q groups of IO data streams have a same data length.

22. The method according to any one of claims 19 to 21, wherein the single-bit error correction ECC encoding comprises extended Hamming codes for implementing SEC-DED.

23. The method according to claim 22, wherein the extended Hamming codes for implementing SEC-DED comprise optimal minimum odd-weight-column codes.

24. The method according to any one of claims 19 to 23, wherein a value of N is any one of 3, 4, 6, 8, or 16.

25. A computer-readable storage medium, wherein the readable storage medium is configured to store instructions, and when the instructions are executed, the method according to any one of claims 13 to 18 is implemented or the method according to any one of claims 19 to 24 is implemented.

26. A computer program product, wherein the computer program product stores instructions, and when the instructions are run on a computer, the method according to any one of claims 13 to 18 is performed or the method according to any one of claims 19 to 24 is performed.

27. A data transmission system, comprising the apparatus according to any one of claims 1 to 6 and the apparatus according to any one of claims 7 to 12.

UI | 0 | 1 | 2 |

NRZ

Chiplet A (transmit end)

Channel transmission

Chiplet B (receive end)

UI | 0 | 1 |

PAM-3

Chiplet A (transmit end)

Channel transmission

Chiplet B (receive end)

FIG. 1

0    1    0    0        0    1

One period

FIG. 2

| Output data | Output level (two periods) |
|---|---|
| 000 | |
| 001 | |
| 011 | |
| 100 | |
| 101 | |
| 111 | |
| Not specified | |
| 010 | |
| 110 | |

FIG. 3A

| Value before PAM-3 encoding | | | Tx Ho | Tx Lo | Tx He | Tx Le |
|---|---|---|---|---|---|---|
| A | B | C | Ho | Lo | He | Le |
| 1 | 1 | 1 | 1 | 0 | 0 | 0 |

| | Value after PAM-3 decoding | | | Rx Ho | Rx Lo | Rx He | Rx Le |
|---|---|---|---|---|---|---|---|
| | A | B | C | Ho | Lo | He | Le |
| 1-bit error | 1 | 1 | 1 | 1 | 1 | 0 | 1 |
| | 1 | 0 | 1 | 0 | 1 | 0 | 1 |
| | 1 | 1 | 0 | 1 | 1 | 0 | 0 |
| | 0 | 1 | 1 | 1 | 1 | 1 | 1 |
| 2-bit error | 0 | 1 | 0 | 0 | 0 | 0 | 1 |

| Value before transmit-end PAM-3 encoding | | | Tx Ho | Tx Lo | Tx He | Tx Le |
|---|---|---|---|---|---|---|
| A | B | C | Ho | Lo | He | Le |
| 1 | 1 | 0 | 1 | 0 | 0 | 1 |

| | Value after receive-end PAM-3 decoding | | | Rx Ho | Rx Lo | Rx He | Rx Le |
|---|---|---|---|---|---|---|---|
| | A | B | C | Ho | Lo | He | Le |
| 1-bit error | 1 | 1 | 0 | 1 | 1 | 0 | 0 |
| | 1 | 0 | 0 | 0 | 1 | 0 | 0 |
| | 1 | 1 | 1 | 1 | 1 | 0 | 1 |
| 2-bit error | 0 | 0 | 0 | 0 | 0 | 0 | 0 |
| | 0 | 1 | 1 | 1 | 1 | 1 | 1 |

| Value before transmit-end PAM-3 encoding | | | Tx Ho | Tx Lo | Tx He | Tx Le |
|---|---|---|---|---|---|---|
| A | B | C | Ho | Lo | He | Le |
| 0 | 0 | 1 | 0 | 0 | 1 | 0 |

| | Value after receive-end PAM-3 decoding | | | Rx Ho | Rx Lo | Rx He | Rx Le |
|---|---|---|---|---|---|---|---|
| | A | B | C | Ho | Lo | He | Le |
| 1-bit error | 0 | 0 | 1 | 0 | 1 | 1 | 1 |
| | 0 | 1 | 1 | 0 | 0 | 1 | 1 |
| | 0 | 1 | 1 | 1 | 1 | 1 | 1 |
| | 1 | 0 | 1 | 0 | 1 | 0 | 1 |
| 2-bit error | 1 | 0 | 0 | 0 | 1 | 0 | 0 |

| Value before transmit-end PAM-3 encoding | | | Tx Ho | Tx Lo | Tx He | Tx Le |
|---|---|---|---|---|---|---|
| A | B | C | Ho | Lo | He | Le |
| 1 | 0 | 1 | 0 | 0 | 0 | 0 |

| | Value after receive-end PAM-3 decoding | | | Rx Ho | Rx Lo | Rx He | Rx Le |
|---|---|---|---|---|---|---|---|
| | A | B | C | Ho | Lo | He | Le |
| | 1 | 0 | 1 | 0 | 1 | 0 | 1 |
| | 0 | 1 | 0 | 0 | 0 | 0 | 1 |
| 1-bit error | 1 | 0 | 0 | 0 | 1 | 0 | 0 |
| | 1 | 1 | 1 | 1 | 1 | 0 | 1 |
| | 0 | 0 | 1 | 0 | 1 | 1 | 1 |

| Value before transmit-end PAM-3 encoding | | | Tx Ho | Tx Lo | Tx He | Tx Le |
|---|---|---|---|---|---|---|
| A | B | C | Ho | Lo | He | Le |
| 1 | 0 | 0 | 0 | 0 | 0 | 1 |

| | Value after receive-end PAM-3 decoding | | | Rx Ho | Rx Lo | Rx He | Rx Le |
|---|---|---|---|---|---|---|---|
| | A | B | C | Ho | Lo | He | Le |
| | 1 | 0 | 0 | 0 | 1 | 0 | 0 |
| 1-bit error | 0 | 0 | 0 | 0 | 0 | 0 | 0 |
| | 1 | 1 | 0 | 1 | 1 | 0 | 0 |
| | 1 | 0 | 1 | 0 | 1 | 0 | 1 |
| 2-bit error | 0 | 0 | 1 | 0 | 1 | 1 | 1 |

| Value before transmit-end PAM-3 encoding | | | Tx Ho | Tx Lo | Tx He | Tx Le |
|---|---|---|---|---|---|---|
| A | B | C | Ho | Lo | He | Le |
| 0 | 1 | 1 | 0 | 1 | 1 | 0 |

| | Value after receive-end PAM-3 decoding | | | Rx Ho | Rx Lo | Rx He | Rx Le |
|---|---|---|---|---|---|---|---|
| | A | B | C | Ho | Lo | He | Le |
| | 0 | 1 | 1 | 0 | 0 | 1 | 1 |
| 1-bit error | 0 | 0 | 1 | 0 | 1 | 1 | 1 |
| | 0 | 1 | 0 | 0 | 0 | 0 | 1 |
| 2-bit error | 0 | 1 | 1 | 1 | 1 | 1 | 1 |
| | 0 | 0 | 0 | 0 | 0 | 0 | 0 |

| Value before transmit-end PAM-3 encoding | | | Tx Ho | Tx Lo | Tx He | Tx Le |
|---|---|---|---|---|---|---|
| A | B | C | Ho | Lo | He | Le |
| 0 | 1 | 0 | 0 | 1 | 0 | 0 |

| | Value after receive-end PAM-3 decoding | | | Rx Ho | Rx Lo | Rx He | Rx Le |
|---|---|---|---|---|---|---|---|
| | A | B | C | Ho | Lo | He | Le |
| | 0 | 1 | 0 | 0 | 0 | 0 | 1 |
| 1-bit error | 1 | 0 | 1 | 0 | 1 | 0 | 1 |
| | 0 | 1 | 1 | 0 | 0 | 1 | 1 |
| 2-bit error | 1 | 1 | 1 | 1 | 1 | 0 | 1 |

| Value before transmit-end PAM-3 encoding | | | Tx Ho | Tx Lo | Tx He | Tx Le |
|---|---|---|---|---|---|---|
| A | B | C | Ho | Lo | He | Le |
| 0 | 0 | 0 | 0 | 1 | 0 | 1 |

| | Value after receive-end PAM-3 decoding | | | Rx Ho | Rx Lo | Rx He | Rx Le |
|---|---|---|---|---|---|---|---|
| | A | B | C | Ho | Lo | He | Le |
| | 0 | 0 | 0 | 0 | 0 | 0 | 0 |
| 1-bit error | 1 | 0 | 0 | 0 | 1 | 0 | 0 |
| | 0 | 1 | 0 | 0 | 0 | 0 | 1 |
| 2-bit error | 1 | 1 | 0 | 1 | 1 | 0 | 0 |
| | 0 | 1 | 1 | 0 | 0 | 1 | 1 |

FIG. 3B

Chiplet A (transmit end) → Channel → Chiplet B (receive end)

FIG. 4

FIG. 5

N groups of data bit streams

An ECC encoder 11 performs single-bit error correction ECC encoding on the N groups of data bit streams — S601A

N groups of ECC encoded bit streams

An interleaver 12 reads encoded bits from the N groups of ECC encoded bit streams in a polling manner, and reassembles the encoded bits — S602A

First encoded bit stream

An IO data distributor 13 distributes all units of the first encoded bit stream to Q IO pins — S603A

Q groups of IO data streams

A PAM encoder 14 performs PAM-N encoding on the Q groups of IO data streams — S604A

Q groups of PAM encoded bit streams

FIG. 6A

Q groups of PAM encoded bit streams

| A PAM decoder 21 performs PAM-N decoding on the Q groups of PAM encoded bit streams | S601B |

Q groups of IO data streams

| A first aggregator 22 aggregates the Q groups of IO data streams | S602B |

First encoded bit stream

| A de-interleaver 23 reads encoded bits from all units of the first encoded bit stream, and reassembles the encoded bits into N groups of ECC encoded bit streams | S603B |

N groups of ECC encoded bit streams

| An ECC decoder 24 performs single-bit error correction ECC decoding on the N groups of ECC encoded bit streams | S604B |

N groups of data bit streams

FIG. 6B

First group of data bit stream → ECC encoder 11-1 → First group of ECC encoded bit stream

Second group of data bit stream → ECC encoder 11-2 → Second group of ECC encoded bit stream

...

$N^{th}$ group of data bit stream → ECC encoder 11-N → $N^{th}$ group of ECC encoded bit stream

→ Interleaver 12 → IO data distributor 13

IO-1
IO-2
IO-Q

→ PAM encoder 14 →

IO-1
IO-2
IO-Q

01

FIG. 7

First group of
ECC encoded
bit stream

| A_0 |
| A_1 |
| A_2 |
| A_3 |
| ... |

First encoded bit stream

Second group of
ECC encoded
bit stream

| B_0 |
| B_1 |
| B_2 |
| B_3 |
| ... |

| A_0 | B_0 | C_0 | A_1 | B_1 | C_1 | ... |

Third group of
ECC encoded
bit stream

| C_0 |
| C_1 |
| C_2 |
| C_3 |
| ... |

FIG. 8

First encoded bit stream

FIG. 9

EP 4 589 439 A1

FIG. 10

FIG. 11

FIG. 12

FIG. 13

First encoded bit stream

| | |
|---|---|
| A_0 | |
| B_0 | |
| C_0 | |
| A_1 | |
| B_1 | |
| C_1 | |
| A_2 | |
| B_2 | |
| C_2 | |
| ... | |

| A0 | B0 | C0 | ... | IO-0 |
|---|---|---|---|---|

| A1 | B1 | C1 | ... | IO-1 |
|---|---|---|---|---|

| A2 | B2 | C2 | ... | IO-2 |
|---|---|---|---|---|

FIG. 14

First group of
ECC encoded
bit stream

| A_0 |
| A_1 |
| A_2 |
| A_3 |
| ... |

First encoded bit stream

| A_0 | B_0 | C_0 | A_1 | B_1 | C_1 | ... |

Second group of
ECC encoded bit
stream

| B_0 |
| B_1 |
| B_2 |
| B_3 |
| ... |

Third group of
ECC encoded
bit stream

| C_0 |
| C_1 |
| C_2 |
| C_3 |
| ... |

FIG. 15

FIG. 16

02

Inputs: IO-1, IO-2, ..., IO-Q

PAM decoder 21 → First aggregator 22 → De-interleaver 23

First group of ECC encoded bit stream → ECC decoder 24_1 → First group of data bit stream

Second group of ECC encoded bit stream → ECC decoder 24_2 → Second group of data bit stream

$N^{th}$ group of ECC encoded bit stream → ECC decoder 24_3 → $N^{th}$ group of data bit stream

FIG. 17

CC[7] | CB[7] | CA[7] | ⋯ | CC[0] | CB[0] | CA[0]

DC[119] | DB[119] | DA[119] | ⋯ | DC[0] | DB[0] | DA[0]

CA[7:0]
DA[119:0]

CB[7:0]
DB[119:0]

CC[7:0]
DC[119:0]

IO 0
IO 1
⋯
IO 63

PAM decoder 21

First aggregator 22

De-interleaver 23

ECC decoding A

ECC decoding B

ECC decoding C

DA[119:0]

DB[119:0]

DC[119:0]

Second aggregator 25

DATA[120*3–1:0]

IO 0: | DC[64] | DB[64] | DA[64] | DC[0] | DB[0] | DA[0]

IO 1: | DC[65] | DB[65] | DA[65] | DC[1] | DB[1] | DA[1]

⋯

IO 63: | CC[7] | CB[7] | CA[7] | DC[63] | DB[63] | DA[63]

FIG. 18

FIG. 19

## INTERNATIONAL SEARCH REPORT

| International application No. |
| --- |
| **PCT/CN2022/128727** |

### A. CLASSIFICATION OF SUBJECT MATTER

G06F11/26(2006.01)i;  G06F11/10(2006.01)i

According to International Patent Classification (IPC) or to both national classification and IPC

### B. FIELDS SEARCHED

Minimum documentation searched (classification system followed by classification symbols)

IPC:G06F11/-

Documentation searched other than minimum documentation to the extent that such documents are included in the fields searched

Electronic data base consulted during the international search (name of data base and, where practicable, search terms used)

3GPP, CJFD, CNTXT, ENTXTC, IETF, IPCOM, VEN, WPABSC, ENTXT: 编码, 单比特, 单纠错, 交织, 交错, 解码, 晶粒, 晶片, 纠错, 裸片, 脉冲幅度调制, 双检错, 芯粒, 重组, cod+, decod+, error, correct+, detect+, bit, chip, chiplet, ECC, PAM, SEC, single, double, interleav+

### C. DOCUMENTS CONSIDERED TO BE RELEVANT

| Category* | Citation of document, with indication, where appropriate, of the relevant passages | Relevant to claim No. |
| --- | --- | --- |
| X | CN 113495815 A (INTEL CORP.) 12 October 2021 (2021-10-12) description, paragraphs [0063]-[0093] | 1-27 |
| A | CN 113454602 A (MICRON TECHNOLOGY, INC.) 28 September 2021 (2021-09-28) entire document | 1-27 |
| A | CN 112506730 A (INFORMATION ENGINEERING UNIVERSITY OF PLA) 16 March 2021 (2021-03-16) entire document | 1-27 |
| A | CN 112860610 A (INTEL CORP.) 28 May 2021 (2021-05-28) entire document | 1-27 |
| A | US 2020278908 A1 (MICRON TECHNOLOGY, INC.) 03 September 2020 (2020-09-03) entire document | 1-27 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **14 July 2023** | **20 July 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| --- |
| **PCT/CN2022/128727** |

| Patent document cited in search report | | | Publication date (day/month/year) | Patent family member(s) | | | Publication date (day/month/year) |
| --- | --- | --- | --- | --- | --- | --- | --- |
| CN | 113495815 | A | 12 October 2021 | EP | 3893415 | A1 | 13 October 2021 |
| | | | | US | 2020364129 | A1 | 19 November 2020 |
| CN | 113454602 | A | 28 September 2021 | US | 2022066867 | A1 | 03 March 2022 |
| | | | | US | 11663075 | B2 | 30 May 2023 |
| | | | | KR | 20220009506 | A | 24 January 2022 |
| | | | | KR | 20210118474 | A | 30 September 2021 |
| | | | | KR | 102352217 | B1 | 17 January 2022 |
| | | | | WO | 2020172185 | A1 | 27 August 2020 |
| | | | | EP | 3928206 | A1 | 29 December 2021 |
| | | | | EP | 3928206 | A4 | 22 June 2022 |
| | | | | US | 2020264950 | A1 | 20 August 2020 |
| | | | | US | 11126498 | B2 | 21 September 2021 |
| CN | 112506730 | A | 16 March 2021 | CN | 112506730 | B | 01 November 2022 |
| CN | 112860610 | A | 28 May 2021 | BR | 102020019435 | A2 | 08 June 2021 |
| | | | | EP | 3829090 | A1 | 02 June 2021 |
| | | | | US | 2020226018 | A1 | 16 July 2020 |
| | | | | JP | 2021087216 | A | 03 June 2021 |
| | | | | TW | 202134872 | A | 16 September 2021 |
| US | 2020278908 | A1 | 03 September 2020 | US | 11061771 | B2 | 13 July 2021 |
| | | | | WO | 2020180804 | A1 | 10 September 2020 |
| | | | | US | 2021311829 | A1 | 07 October 2021 |
| | | | | US | 11675662 | B2 | 13 June 2023 |
| | | | | KR | 20210125106 | A | 15 October 2021 |
| | | | | EP | 3931701 | A1 | 05 January 2022 |
| | | | | EP | 3931701 | A4 | 14 September 2022 |

Form PCT/ISA/210 (patent family annex) (July 2022)